# EUROPÄISCHE PATENTSCHRIFT

(11) **EP 2 808 672 B1**
(45) Veröffentlichungstag und Bekanntmachung des Hinweises auf die Patenterteilung: **31.10.2018**
(21) Anmeldenummer: 14176570.1
(22) Anmeldetag: 26.02.2010
(51) Int. Cl.: G01N 21/64, G01N 21/59, B07C 5/34, B07C 5/342

(54) **Gehäuse für eine UV-Lichtquelle**
Housing for a UV light source
Boîtier pour une source de lumière UV

(30) Priorität: 19.08.2009 AT 52009 U
(43) Veröffentlichungstag der Anmeldung: 03.12.2014
(62) Teilanmeldung aus: 10709457.5
(73) Patentinhaber: Binder + Co AG, 8200 Gleisdorf (AT)
(72) Erfinder: Huber, Reinhold, 8280 Fürstenfeld (AT); Leitner, Karl, 8184 Anger (AT)
(74) Vertreter: KLIMENT & HENHAPEL

(56) Entgegenhaltungen:
- WO-A1-2004/063729
- US-A- 4 747 645
- US-A1- 2006 139 931

## Beschreibung

### GEBIET DER ERFINDUNG

Die vorliegende Erfindung bezieht sich auf ein Gehäuse für eine UV-Lichtquelle.

Das Gehäuse kann in einem Verfahren zum Detektieren von bleihältigen Glasstücken in einem einschichtigen Materialstrom von Objekten aus vorwiegend Altglas eingesetzt werden, wobei die Objekte mit im Wesentlichen monochromatischem UV-Licht bestrahlt und das daraus resultierende Fluoreszenzlicht detektiert wird.

### STAND DER TECHNIK

Altglas enthält in der Regel Normalglasscherben, kann aber auch bleihältige Glasstücke (Bleiglas) enthalten.

Zum Zwecke der Farbsortierung und Fremdstofferkennung werden zumeist berührungslose Messmethoden mittels Infrarot- oder RGB-Sensoren eingesetzt, welche anhand des registrierten Transmissions- oder Absorptionsgrades von auf den Altglasmaterialstrom gerichtetem Licht ein Ausscheiden der unerwünschten Fremdstoffe aus dem Altglasmaterialstrom bzw. ein Ablenken von farbigen Gläsern in dafür vorgesehene Fraktionen durch nachgeschaltete Ausblas- oder Saugdüsen einleiten. Das auszusortierende Stückgut des gemischten Altglasmaterialstromes wird etwa auf einem Sortierband oder während einer Freifallstrecke durch Strahlungsquellen bestrahlt und die durch den Altglasmaterialstrom hindurchgehende oder reflektierte Strahlung in ihrer Intensität von einer Detektiereinheit aufgenommen und mit Referenzwerten verglichen. Eine mit der Detektiereinheit in Datenverbindung stehende Auswerte- und Steuereinheit nimmt in der Folge eine Zuordnung des Stückgutes zu einer jeweiligen Fraktion vor und veranlasst ein Erfassen desselben durch Aufnehmer oder ein Ablenken in vorbestimmte Container mittels Druckluft- oder Saugdüsen.

Ein Problemkreis, der bisher beim Glas-Recycling nur von untergeordneter Bedeutung war, in letzter Zeit aber zunehmend an Brisanz gewinnt, ist jedoch die Erkennung von Sonderglas im Altglasmaterialstrom. Als Sondergläser werden eigens für spezielle Anwendungen kreierte Glassorten bezeichnet, die im Vergleich zu Normalglas (Kalknatron-Glas) stark abweichende chemische und physikalische Eigenschaften, insbesondere einen wesentlich höheren Schmelzpunkt sowie bessere thermische Eigenschaften aufweisen. Hierzu zählen etwa Glaskeramik, Quarzglas, Bleiglas sowie temperatur- und hitzeschockbeständige technische Gläser wie Borosilikatgläser. Der primäre Herstellungsprozess von Sonderglas gleicht demjenigen bei der Normalglaserzeugung, jedoch wird der Glasschmelze je nach Anwendungsgebiet ein gewisser Anteil an speziellen Oxiden beigefügt.

Die sogenannten Bleigläser bzw. bleihaltige Glasstücke enthalten Bleioxide. Sie sind einerseits als sogenanntes Bleikristallglas zwar aufgrund ihrer starken Lichtbrechung und guten Oberflächenbearbeitbarkeit sehr beliebt, müssen aus Umwelt- und Gesundheitsgründen jedoch unbedingt in speziellen Glashütten wiederaufbereitet werden, wo sie unter kontrollierten Bedingungen wiedereingeschmolzen werden. Andererseits fallen unter Bleiglas auch Bildschirme (Kathodenstrahlröhrenbildschirme), deren Bestandteile einen unterschiedlichen Anteil an Bleioxid PbO aufweisen: das Frontglas, das den sichtbaren Teil des Bildschirms bildet, weist einen Gehalt von 0,1-4% PbO auf, bei bleiarmen bzw. bleifreien Fronten liegt der Gehalt bei < 0,1% PbO. Das Konusglas weist allerdings einen Gehalt von 10-25% PbO auf. Bruchteile von Bildschirmen gehören daher entweder zum Frontglas, zum Konusglas oder zum Übergangsbereich zwischen Front und Konus, diese Glasstücke werden als Front/Konus-Fritten bezeichnet und können einen eigene aus zu sortierende Klasse von Glasstücken darstellen.

Bekannte Verfahren zur Sortierung von Sonderglas arbeiten mit der Eigenschaft der Fluoreszenz von Sonderglas. Hierbei wird Glas mit UV-Licht einer bestimmten Wellenlänge bestrahlt, worauf es in einem engen, sichtbaren Spektralbereich zu fluoreszieren beginnt, da das eingestrahlte Licht von im oxidischen Glas vorhandenen Verunreinigungen teilweise absorbiert und in Fluoreszenzstrahlung konvertiert wird. Anhand der Fluoreszenzfarbe können dann Rückschlüsse auf die Art des Sonderglases gezogen werden. Das zu verwendende UV-Licht ist abhängig von der Art des auszusortierenden Sonderglases. Ein solches Verfahren ist etwa aus der WO2004/063729A1 bekannt, mit dem unter anderem Bleigläser erkannt und aussortiert werden können.

Um unerwünschte Wellenlängen, insbesondere jene des sichtbaren Lichts, aus dem Spektrum der UV-Lichtquelle eliminieren zu können, sollte das UV-Licht gefiltert werden.

Aus der US 7 550 746 B2 ist es bekannt, das Licht einer UV-Lampe vor dem Erzeugen von Fluoreszenzlicht auf einen "UV dichroic mirror" zu lenken. Aus der US 4 747 645 A ist es bekannt, Licht einer UV-Lampe durch zwei normal zueinander angeordnete UV-Spiegel umzulenken.

### DARSTELLUNG DER ERFINDUNG

Es ist daher eine Aufgabe der vorliegenden Erfindung, ein Gehäuse für eine UV-Lichtquelle zur Verwendung in einem Verfahren zum Detektieren von bleihältigen Glasstücken zur Verfügung zu stellen, wobei das Gehäuse unerwünschte Wellenlängen, insbesondere jene des sichtbaren Lichts, aus dem Spektrum der UV-Lichtquelle eliminiert.

Diese Aufgabe wird durch ein Gehäuse nach Anspruch 1 gelöst, indem die UV-Lichtquelle so in das Gehäuse, welches einen Reflektor und zumindest einen Spiegelfilter enthält, eingebaut werden kann, dass das Licht aus der UV-Lichtquelle durch den Reflektor, der in einer ersten Richtung angeordnet ist, in die Gegenrichtung zur ersten Richtung geleitet wird und über zumindest einen Spiegelfilter umgelenkt und gefiltert wird, nämlich durch zwei normal zueinander angeordnete Spiegelfilter um 180° umgelenkt und somit in die erste Richtung geleitet wird zu einem einzigen UV-Lichtdurchtritt des Gehäuses, wobei die Spiegelfilter Spiegel sind, die mit einer Beschichtung versehen sind, welche einen Großteil des von der UV-Lichtquelle emittierten Lichts im sichtbaren Bereich absorbiert.

Zum Einsatz kommt eine im Wesentlichen monochromatische UV-Lichtquelle, mit welcher ein einschichtiger Materialstrom von Objekten aus vorwiegend Altglas beleuchtet werden kann.

Bevorzugte Ausführungsformen sind einerseits UV-Lichtquellen mit etwa 270 nm Wellenlänge und Detektoren für Fluoreszenzlicht im Wellenlängenbereich von 380-450 nm und andererseits UV-Lichtquellen mit etwa 254 nm Wellenlänge und Detektoren für Fluoreszenzlicht im Wellenlängenbereich von 420-500 nm.

### KURZE BESCHREIBUNG DER FIGUREN

Die Erfindung wird nun anhand schematischer Figuren näher erläutert. In beiden Fällen kommt das Gegenlichtverfahren zur Anwendung, das heißt, UV-Lichtquelle und Detektor für Fluoreszenzstrahlung sind auf unterschiedlichen Seiten des Altglas-Materialstroms angeordnet.
Fig. 1 zeigt eine Vorrichtung mit Gehäuse nach dem Stand der Technik mit Filtern für die UV-Lichtquelle,
Fig. 2 zeigt eine Vorrichtung mit erfindungsgemäßem Gehäuse mit Spiegelfiltern für die UV-Lichtquelle.

### WEGE ZUR AUSFÜHRUNG DER ERFINDUNG

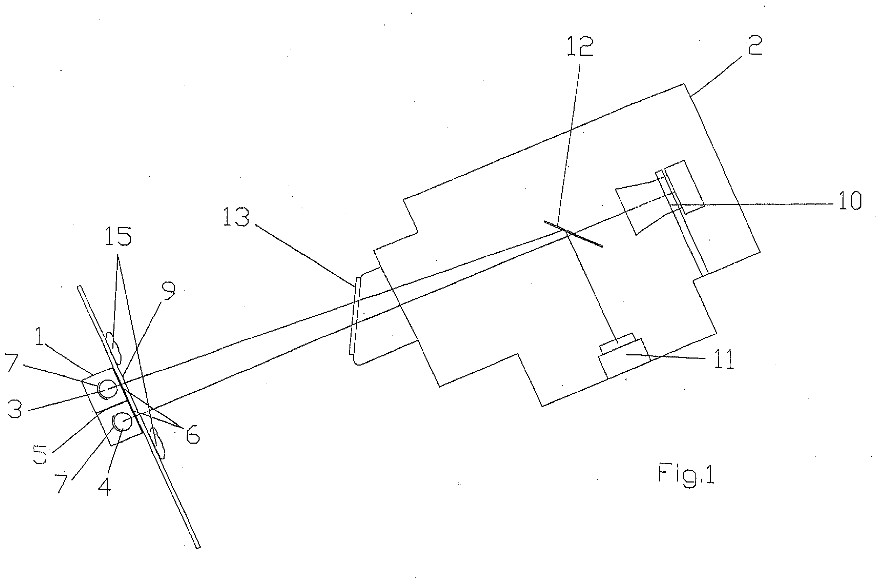

In Fig. 1 sind nach dem Stand der Technik in einem Gehäuse 1 für Lichtquellen sowohl eine UV-Lichtquelle 3 als auch eine zweite Lichtquelle 4 eingebaut.

Die UV-Lichtquelle 3 kann UV-Licht im Bereich von 100-280 nm aussenden, insbesondere zwischen 250 und 275 nm. Sie kann in Form einer UV-C-Leuchte ausgeführt sein, die auch UV-C Leuchtstofflampe oder UV-C Leuchtstoffröhre genannt wird. Ebenso können statt einer UV-Röhre auch eine oder mehrere UV-C LEDs (LED-Line) zu Anwendung kommen.

Die zweite Lichtquelle 4 kann Licht im sichtbaren Bereich (380-780 nm Wellenlänge) und/oder im Infrarotbereich (780 nm - 1 mm Wellenlänge) aussenden und etwa - wie in diesem Beispiel - als Leuchtstofflampe (VIS-Leuchte) mit Wellenlängen im sichtbaren Bereich ausgeführt sein. Statt einer Lampe (VIS-Leuchte) können auch eine oder mehrere Farb- oder Infrarot-LEDs (LED-Line) verwendet werden.

LEDs haben gegenüber Röhrenleuchten mehrere Vorteile:
- bessere Regelbarkeit der Intensität
- höhere Intensität
- viele unterschiedliche und auch enge Wellenlängenbereiche möglich
- Beleuchtungsbreite (LED-Line) bzw. beleuchtet Fläche durch Anordnung mehrerer LEDs frei wählbar
- Vorgabe eines Intensitätsprofils möglich

Der Nachteil, zumindest von LEDs im UV-C-Bereich, sind die derzeit hohen Anschaffungskosten und der höhere Diffusierungsaufwand im Vergleich zu Röhrenleuchten.

Die beiden Lichtquellen 3, 4 sind durch eine lichtundurchlässige Trennwand 5 voneinander getrennt.

Im gegenständlichen Beispiel in Fig. 1 emittiert eine UV-C-Leuchte 3 UV-C-Strahlung mit einer maximalen Intensität bei einer Wellenlänge von 254 nm und ist so im Gehäuse 1 eingebaut, dass das UV-Licht durch einen hinter der UV-C-Leuchte 3 angeordneten Reflektor 7 in Richtung zu den Detektoren hin geleitet wird. Das UV-Licht durchläuft noch einen Filter 6, der einen Großteil des von der UV-C-Leuchte 3 emittierten Lichts im sichtbaren Bereich absorbiert und somit nahezu kein sichtbares Licht im Wellenlängenbereich des Fluoreszenzlichts zu den Detektoren leitet. Würde nämlich etwa blaues Licht von der UV-C-Leuchte 3 zum Detektor für Fluoreszenzlicht gelangen, würde dieses als Fluoreszenzstrahlung detektiert werden, weil diese ebenfalls im Bereich des blauen Lichts liegt.

Das von der zweiten Lichtquelle emittierte VIS-Licht durchläuft ebenfalls einen Filter 6, der emittiertes Licht im UV- und fluoreszierenden Bereich (< 500 nm) absorbiert.

Das Gehäuse 1 besteht zumindest im Bereich des UV-Lichtdurchtritts aus einer Quarzglasscheibe 9. Quarzglas weist einen hohe Durchlässigkeit für UV-C-Licht auf. Die Quarzglasscheibe 9 kann aber auch den Lichtdurchtritt des sichtbaren Lichts abdecken.

Die Quarzglasscheibe 9 dient auch als Rutsche für die zu untersuchenden Objekte 15 (Glasscherben, Störstoffe). Sie weist - im montierten Zustand der Vorrichtung - eine Neigung von etwa 25° gegenüber der Senkrechten auf. Auf ihr rutschen die Objekte 15 nach unten und werden dabei von den beiden Lichtquellen 3, 4 beleuchtet.

Der Abstand zwischen dem zu detektierenden Fluoreszenzlicht und dem zu detektierenden Transmissionslicht (aus Lichtquelle 4) sollte möglichst gering (im Idealfall deckungsgleich) sein, damit beide Detektoren, jener für Fluoreszenz- und jener für Transmissionslicht, ein möglichst übereinstimmendes Bild des bewegten Objekts 15 abbilden können. Der Abstand zwischen den Mittelachsen der Lichtstrahlen des sichtbaren Lichts bzw. des UV-Lichts, wenn diese aus dem Gehäuse 1 austreten, beträgt in diesem Beispiel etwa 50mm.

Sowohl das von den Objekten durchgelassene sichtbare Licht der VIS-Leuchte 4 als auch die gegebenenfalls durch das UV-Licht induzierte Fluoreszenzstrahlung im blauen sichtbaren Bereich gelangen durch ein Schutzglas 13 in das weitere Gehäuse 2, wo einerseits ein Detektor 11 zum Detektieren des Fluoreszenzlichts angebracht ist, und wo andererseits auch ein Detektor zum Detektieren des Transmissionslichts der zweiten Lichtquelle 4 angeordnet ist.

Das Schutzglas 13 besteht aus Normalglas und schützt den Innenraum von Gehäuse 2 vor Staub und UV-C Strahlung.

Der Detektor 11 zum Detektieren des Fluoreszenzlichts ist in einem Wellenlängenbereich von 400-1000 nm empfindlich, die Empfindlichkeit kann durch Filter weiter verändert werden, etwa hier auf den relevanten Wellenlängenbereich von 420-500 nm. (Würde man UV-Licht mit einer Wellenlänge von etwa 270 nm verwenden, so würde man das Filter so einstellen, dass nur Fluoreszenzlicht im Wellenlängenbereich von 400-450 nm detektiert werden kann). Der Detektor 11 wird in der Regel als Kamera ausgebildet sein. Er kann zum Beispiel als sogenannte TDI-Kamera 11 ausgebildet sein.

Um eine Störung der Detektion des Fluoreszenzlichts durch eine weitere Lichtquelle in diesem Wellenlängenbereich zu vermeiden, darf die zweite Lichtquelle 4 möglichst nur Licht außerhalb dieses Frequenzbereichs ausstrahlen. In der Praxis ist es oft so, dass selbst Lichtquellen im gelben oder roten Bereich, die also per Definition "Licht im sichtbaren Bereich oder IR-Licht außerhalb des Wellenlängenbereichs des Fluoreszenzlichts aussenden" noch einen Blauanteil im Licht haben, und dieser dann gegebenenfalls herausgefiltert werden muss, wie oben bei Filter 6 für die zweite Lichtquelle 4 erläutert.

Zur Detektion des Transmissionlichts aus der zweiten Lichtquelle 4 ist es grundsätzlich ausreichend, wenn ein Detektor 10, also etwa eine Kamera, zumindest ein Bild von Glasstücken in Grauschattierungen liefern kann. Daraus kann dann einerseits die Lage und Form des Objekts 15 bestimmt werden, die notwendig ist, um das Objekt gegebenenfalls mittels nachgeordneter Austrageinrichtungen aus dem Materialstrom zu entfernen. Andererseits wird dadurch die Lichtdurchlässigkeit des Objekts (Glasstücks) 15 bestimmt und dieses als durchsichtig erkannt (es kann dann noch bleihaltig oder nicht bleihaltig sein) oder als wenig oder nicht durchsichtig (dann wäre es ein Störstoff). Entsprechend wird der Störstoff dann durch die Austrageinrichtungen aus dem Materialstrom entfernt. Es können mittels dieses Detektors auch die Ränder und Innenbereiche der Glasstücke durch Bilderkennung definiert werden und nur von diesen Teilbereichen der Scherbe die Intensität der Fluoreszenzstrahlung zur Auswertung des Bleiglasgehaltes herangezogen werden.

Sowohl Fluoreszenzlicht als auch transmittiertes Licht treffen auf einen Strahlteiler 12, der blaues Licht, etwa im Wellenlängenbereich von 400-500 nm möglichst vollständig reflektiert sowie sichtbares Licht >500 nm (transmittiertes Licht) möglichst vollständig durchlässt. Der reflektierte Lichtstrahl wird in die TDI-Kamera 11 geleitet, der durchgelassene Lichtstrahl in die RGB-Kamera 10.

Die detektierten Daten werden einer Auswerte- und Steuereinheit zugeleitet, welche die einzelnen Glasstücke den verschiedenen Fraktionen
- Bleiglas (gegebenenfalls verschiedene Fraktionen mit unterschiedlichem Bleigehalt),
- Störstoffe (Keramik, Stein und Porzellan, "KSP"),
- Normalglas und
- gegebenenfalls Glaskeramik
zuordnet und die Austrageinheiten steuert, welche die Glasstücke in die entsprechenden Container verbringt.

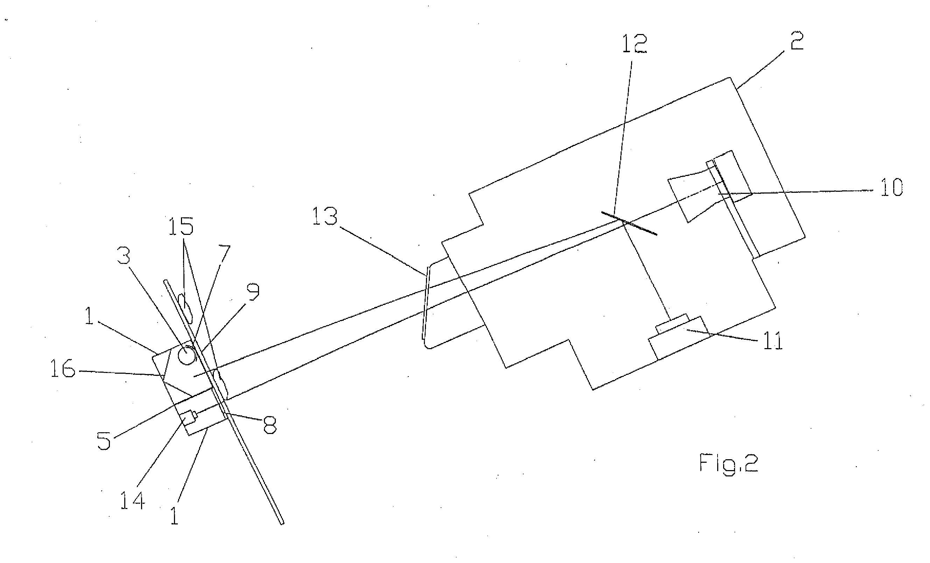

In Fig. 2 sind in einem Gehäuse 1 für Lichtquellen wieder sowohl eine UV-Lichtquelle 3 als auch eine zweite Lichtquelle 14 eingebaut, jedoch durch eine lichtundurchlässige Trennwand 5 voneinander getrennt.

Die UV-Lichtquelle 3 kann UV-Licht im Bereich von 100-280 nm aussenden, insbesondere zwischen 250 und 275 nm. Sie ist hier wieder in Form einer UV-C-Leuchte ausgeführt. Ebenso könnten statt einer UV-Röhre auch eine oder mehrere UV-C LEDs zu Anwendung kommen.

Die zweite Lichtquelle 14 kann Licht im sichtbaren Bereich (380-780 nm Wellenlänge) und/oder im Infrarotbereich (780 nm - 1 mm Wellenlänge) aussenden und etwa - wie in diesem Beispiel - als eine oder mehrere IR-LEDs (LED-Line) ausgeführt sein. Genauso könnte aber auch eine Lampe mit Wellenlängen im sichtbaren Bereich und/oder im Infrarotbereich oder eine oder mehrere Tageslicht- bzw. Farb-LEDs (LED-Line) verwendet werden.

Die UV-C-Leuchte 3 emittiert UV-C-Strahlung mit einer Wellenlänge von 254 nm und ist so im Gehäuse 1 eingebaut, dass das UV-Licht durch einen in Richtung der Detektoren angeordneten Reflektor 7 von den Detektoren weg geleitet und durch zwei rechtwinkelig zueinander angeordnete Spiegelfilter 16 um 180° umgelenkt und somit in Richtung zu den Detektoren hin geleitet wird. Die Spiegelfilter 16 sind Spiegel, die mit einer Beschichtung versehen sind, welche einen Großteil des von der UV-C-Leuchte 3 emittierten Lichts im sichtbaren Bereich absorbiert und somit nahezu kein sichtbares Licht im Wellenlängenbereich des Fluoreszenzlichts reflektiert und zu den Detektoren leitet. Würde nämlich etwa blaues Licht von der UV-C-Leuchte 3 zum Detektor für Fluoreszenzlicht gelangen, würde dieses als Fluoreszenzstrahlung detektiert werden, weil diese ebenfalls im Bereich des blauen Lichts liegt.

Zusätzlich zu den beschichteten Spiegelfiltern 16 könnten auch Filter für sichtbares Licht im Wellenlängenbereich des Fluoreszenzlichts in den Strahlengang des UV-Lichts gebracht werden.

Spiegelfilter 16 haben den Vorteil, dass sie auch in großen Breiten, etwa 1000mm, kostengünstig hergestellt werden können, welche der Breite von Förderbändern bzw. der Rutsche für Altglas entspricht. Klassische Filter haben einerseits den Nachteil, dass diese oft nur in kleinen Breiten (<200mm) hergestellt werden können und somit kein einstückiger Filter für die erfindungsgemäße Vorrichtung hergestellt werden kann, der die gesamte Breite des Förderbandes bzw. der Rutsche für Altglas abdecken kann.

Ein Spiegelfilter 16 hat in diesem Beispiel eine Höhe (gemessen in der Zeichenebene) von etwa 5-10 cm, insbesondere hier 7 cm. Die Breite (gemessen normal zu Zeichenebene) beträgt 50-150 cm, insbesondere hier 100 cm.

Als Grundmaterial für den Spiegelfilter 16 wird ein Metallblech mit einer Dicke von 1-2 mm verwendet. Die Beschichtung besteht aus Oxiden und hat eine Dicke von einigen Mikrometern.

Das IR-Licht der IR-LEDs 14 wird durch eine Streuscheibe 8 geleitet, um das Licht der punktförmigen IR-LEDs 14 homogener zu machen, und tritt parallel zum UV-Licht aus dem Gehäuse 1 aus. Statt einer Streuscheibe 8 können auch andere Einrichtungen verwendet werden, um das Licht gleichmäßiger zu verteilen, etwa ein auf seinen Innenseiten verspiegelter Reflexionskanal, wie er in der AT 10184 U1 gezeigt ist.

Das Gehäuse 1 besteht zumindest im Bereich des UV-Lichtdurchtritts aus einer Quarzglasscheibe 9 wie in Fig. 1. Die Quarzglasscheibe 9 kann aber auch hier den Lichtdurchtritt der zweiten Lichtquelle, der IR-LEDs 14, abdecken und als Rutsche für die zu untersuchenden Objekte dienen.

Der Abstand zwischen dem zu detektierenden Fluoreszenzlicht und dem zu detektierenden Transmissionslicht sollte auch hier möglichst gering (idealer Weise deckend) sein, damit beide Detektoren, jener für Fluoreszenz- und jener für Transmissionslicht, ein möglichst übereinstimmendes Bild des bewegten Objekts abbilden können. Der Abstand zwischen den Mittelachsen der Lichtstrahlen des IR-Lichts bzw. des UV-Lichts, wenn diese aus dem Gehäuse 1 austreten, beträgt in diesem Beispiel ebenfalls etwa 50mm.

Sowohl das von den Objekten 15 durchgelassene IR-Licht der IR-LEDs 14 als auch die gegebenenfalls durch das UV-Licht induzierte Fluoreszenzstrahlung im blauen sichtbaren Bereich gelangen durch ein Schutzglas 13 - wie unter Fig. 1 beschrieben - in das weitere Gehäuse 2, wo einerseits ein Detektor 11 zum Detektieren des Fluoreszenzlichts angebracht ist, der wie unter Fig. 1 beschrieben auszubilden ist und der auch hier in Fig. 2 als sogenannte TDI-Kamera 11 ausgebildet ist, und wo andererseits auch ein Detektor 10 zum Detektieren des Transmissionslichts der zweiten Lichtquelle 14, der IR-LEDs 14, angeordnet ist. Der Detektor 10, in der Regel wieder eine Kamera, ist daher zumindest in jenem Wellenlängenbereich empfindlich, in dem die zweite Lichtquelle 14 Licht aussendet, also in diesem Fall in einem Bereich innerhalb des Wellenlängenbereichs von 780 nm -1 mm. Es kann auch hier wieder eine RGB-Kamera, gegebenenfalls mit vorgeschaltetem Filter, verwendet werden.

Um eine Störung der Detektion des Fluoreszenzlichts durch eine weitere Lichtquelle in diesem Wellenlängenbereich zu vermeiden, darf die zweite Lichtquelle möglichst nur Licht außerhalb dieses Frequenzbereichs ausstrahlen. Es wurde daher für dieses Anwendungsbeispiel ein bezüglich Wellenlänge möglichst weit vom Fluoreszenzlicht entferntes Licht, nämlich IR-Licht mit einer Wellenlänge von 860 nm, ausgewählt.

Zur Detektion des Transmissionlichts ist es, wie bei Fig. 1 bereits erläutert, grundsätzlich ausreichend, wenn der Detektor 10, also etwa eine Kamera, zumindest ein Bild von Objekten 15 in Grauschattierungen liefern kann. Daraus kann dann einerseits die Lage und Form des Objekts 15 bestimmt werden, die notwendig ist, um das Objekt 15 gegebenenfalls mittels nachgeordneter Austrageinrichtungen aus dem Materialstrom zu entfernen. Andererseits wird dadurch die Lichtdurchlässigkeit des Objekts (Glasstücks) 15 bestimmt und dieses als durchsichtig erkannt (es kann dann noch bleihaltig oder nicht bleihaltig sein) oder als wenig oder nicht durchsichtig (dann wäre es ein Störstoff). Entsprechend wird der Störstoff dann durch die Austrageinrichtungen aus dem Materialstrom entfernt. Es können mittels dieses Detektors auch die Ränder und Innenbereiche der Glasstücke durch Bilderkennung definiert werden und nur von diesen Teilbereichen der Scherbe die Intensität der Fluoreszenzstrahlung zur Auswertung des Bleiglasgehaltes herangezogen werden.

Sowohl Fluoreszenzlicht als auch transmittiertes IR-Licht treffen auf einen Strahlteiler 12, der blaues Licht, etwa im Wellenlängenbereich von 400-500 nm, möglichst vollständig reflektiert sowie IR-Licht, etwa im Wellenlängenbereich von 860 nm, möglichst vollständig durchlässt. Der reflektierte Lichtstrahl wird in die TDI-Kamera 11 geleitet, der durchgelassene Lichtstrahl in die RGB-Kamera 10. Die detektierten Daten werden einer Auswerte- und Steuereinheit zugeleitet, welche die einzelnen Glasstücke den verschiedenen Fraktionen
- Bleiglas (gegebenenfalls verschiedene Fraktionen mit unterschiedlichem Bleigehalt),
- Störstoffe (Keramik, Stein und Porzellan, "KSP"),
- Normalglas und
- gegebenenfalls Glaskeramik
zuordnet und die Austrageinheiten steuert, welche die Glasstücke in die entsprechenden Container verbringt.

### BEZUGSZEICHENLISTE

- 1: Gehäuse für Lichtquellen
- 2: Gehäuse für Detektoren
- 3: UV-Lichtquelle (UV-C-Leuchte)
- 4: Zweite Lichtquelle (VIS-Leuchte)
- 5: Trennwand
- 6: Filter
- 7: Reflektor
- 8: Streuscheibe
- 9: Quarzglasscheibe
- 10: Detektor zur Detektion des Transmissionlichts (RGB-Kamera)
- 11: Detektor zur Detektion des Fluoreszenzlichts (TDI-Kamera)
- 12: Strahlteiler
- 13: Schutzglas
- 14: Zweite Lichtquelle
- 15: Objekt (Glasstück oder Störstoff)
- 16: Spiegelfilter

## Patentansprüche

1. Gehäuse (1) für eine UV-Lichtquelle zur Verwendung in einem Verfahren zum Detektieren von bleihältigen Glasstücken in einem einschichtigen Materialstrom von Objekten aus vorwiegend Altglas, **dadurch gekennzeichnet, dass** die UV-Lichtquelle (3) so in das Gehäuse, welches einen Reflektor (7) und zumindest einen Spiegelfilter (16) enthält, eingebaut werden kann, dass das Licht aus der UV-Lichtquelle (3) durch den Reflektor (7), der in einer ersten Richtung angeordnet ist, in die Gegenrichtung zur ersten Richtung geleitet wird und über zumindest einen Spiegelfilter (16) umgelenkt und gefiltert wird, nämlich durch zwei normal zueinander angeordnete Spiegelfilter (16) um 180° umgelenkt und somit in die erste Richtung geleitet wird zu einem einzigen UV-Lichtdurchtritt des Gehäuses (1), wobei die Spiegelfilter (16) Spiegel sind, die mit einer Beschichtung versehen sind, welche einen Großteil des von der UV-Lichtquelle (3) emittierten Lichts im sichtbaren Bereich absorbiert.

2. Gehäuse (1) nach Anspruch 1, **dadurch gekennzeichnet, dass** eine UV-Lichtquelle (3) eingebaut ist.

3. Gehäuse (1) nach Anspruch 2, **dadurch gekennzeichnet, dass** eine UV-C-Leuchte eingebaut ist.

4. Gehäuse (1) nach Anspruch 2, **dadurch gekennzeichnet, dass** eine oder mehrere UV-C LEDs eingebaut sind.

5. Gehäuse (1) nach einem der Ansprüche 2 bis 4, **dadurch gekennzeichnet, dass** die UV-Lichtquelle (3) UV-Licht mit einer Wellenlänge im Bereich von 100 bis 300 nm, insbesondere zwischen 250 und 275 nm, aussenden kann.

6. Gehäuse (1) nach Anspruch 5, **dadurch gekennzeichnet, dass** das UV-Licht eine Wellenlänge von etwa 270 nm aufweist.

7. Gehäuse (1) nach Anspruch 5, **dadurch gekennzeichnet, dass** das UV-Licht eine Wellenlänge von etwa 254 nm aufweist.

8. Gehäuse (1) nach einem der Ansprüche 1 bis 7, **dadurch gekennzeichnet, dass** die Breite der Spiegelfilter (16) 50-150 cm beträgt.

9. Gehäuse nach einem der Ansprüche 1 bis 8, **dadurch gekennzeichnet, dass** als Grundmaterial für die Spiegelfilter (16) ein Metallblech mit einer Dicke von 1-2 mm verwendet wird.

10. Gehäuse nach Anspruch 9, **dadurch gekennzeichnet, dass** die Beschichtung aus Oxiden besteht.

11. Gehäuse nach Anspruch 10, **dadurch gekennzeichnet, dass** die Beschichtung eine Dicke von einigen Mikrometern hat.

## Claims

1. Housing (1) for a UV light source for use in a method for detecting lead-containing glass pieces in a single-layer material flow of objects of predominantly waste glass, **characterized in that** the UV light source (3) can be installed in the housing, which has a reflector (7) and at least one mirror filter (16), such that the light from the UV light source (3) is directed through the reflector (7), which is arranged in a first direction, in the opposite direction to the first direction and is deflected and filtered via at least one mirror filter (16), namely deflected by 180° by two mirror filters (16) arranged normally to each other and thus directed in the first direction to a single UV light passage of the housing (1), wherein the mirror filters (16) are mirrors, which are provided with a coating which absorbs a majority of the light in the visible range emitted by the UV light source (3).

2. Housing (1) according to claim 1, **characterized in that** a UV light source (3) is installed.

3. Housing (1) according to claim 2, **characterized in that** a UV-C lamp is installed.

4. Housing (1) according to claim 2, **characterized in that** one or more UV-C LEDs are installed.

5. Housing (1) according to one of the claims 2 to 4, **characterized in that** the UV light source (3) can emit UV light having a wavelength in the range of 100 to 300 nm, in particular between 250 and 275 nm.

6. Housing (1) according to claim 5, **characterized in that** the UV light has a wavelength of about 270 nm.

7. Housing (1) according to claim 5, **characterized in that** the UV light has a wavelength of about 254 nm.

8. Housing (1) according to one of the claims 1 to 7, **characterized in that** the width of the mirror filters (16) is 50-150 cm.

9. Housing according to one of the claims 1 to 8, **characterized in that** a metal sheet having a thickness of 1-2 mm is used as base material for the mirror filters (16) .

10. Housing according to claim 9, **characterized in that** the coating consists of oxides.

11. Housing according to claim 10, **characterized in that** the coating has a thickness of a few micrometers.

## Revendications

1. Boîtier (1) pour une source de lumière UV destinée à être utilisée dans un procédé de détection de morceaux de verre contenant du plomb dans un flux de matériau monocouche d'objets composés principalement de verre usagé, **caractérisé en ce que** la source de lumière UV (3) peut être installée dans le boîtier, lequel contient un réflecteur (7) et au moins un filtre miroir (16), de telle sorte que la lumière provenant de la source de lumière UV (3) est dirigée par le réflecteur (7), qui est disposé dans une première direction, dans la direction opposée à la première direction et est déviée et filtrée par au moins un filtre miroir (16), notamment déviée de 180° par deux filtres miroirs (16) disposés perpendiculairement l'un à l'autre et ainsi dirigée dans la première direction vers un unique passage de lumière UV du boîtier (1), les filtres miroirs (16) étant des miroirs qui sont pourvus d'un revêtement qui absorbe la majeure partie de la lumière émise par la source de lumière UV (3) dans le domaine visible.

2. Boîtier (1) selon la revendication 1, **caractérisé en ce qu'**une source de lumière UV (3) est installée.

3. Boîtier (1) selon la revendication 2, **caractérisé en ce qu'**une lampe UV-C est installée.

4. Boîtier (1) selon la revendication 2, **caractérisé en ce qu'**une ou plusieurs LED UV-C sont installées.

5. Boîtier (1) selon l'une des revendications 2 à 4, **caractérisé en ce que** la source de lumière UV (3) peut émettre une lumière UV ayant une longueur d'onde dans la plage de 100 à 300 nm, en particulier comprise entre 250 et 275 nm.

6. Boîtier (1) selon la revendication 5, **caractérisé en ce que** la lumière UV a une longueur d'onde d'environ 270 nm.

7. Boîtier (1) selon la revendication 5, **caractérisé en ce que** la lumière UV a une longueur d'onde d'environ 254 nm.

8. Boîtier (1) selon l'une des revendications 1 à 7, **caractérisé en ce que** la largeur des filtres miroirs (16) est de 50 à 150 cm.

9. Boîtier selon l'une des revendications 1 à 8, **caractérisé en ce qu'**une tôle métallique d'une épaisseur de 1 à 2 mm est utilisée comme matériau de base pour les filtres miroirs (16).

10. Boîtier selon la revendication 9, **caractérisé en ce que** le revêtement est constitué d'oxydes.

11. Boîtier selon la revendication 10, **caractérisé en ce que** le revêtement a une épaisseur de quelques micromètres.
